Europäisches Patentamt

European Patent Office

Office européen des brevets

(19)

(11) Numéro de publication : **0 221 809 B1**

# FASCICULE DE BREVET EUROPEEN

(12)

(45) Date de publication du fascicule du brevet :
**23.01.91 Bulletin 91/04**

(51) Int. Cl.⁵ : **H01L 25/16, H01L 23/52**

(21) Numéro de dépôt : **86402284.3**

(22) Date de dépôt : **14.10.86**

(54) **Circuit hybride et procédé de fabrication d'un tel circuit.**

(30) Priorité : **16.10.85 FR 8515308**

(43) Date de publication de la demande :
**13.05.87 Bulletin 87/20**

(45) Mention de la délivrance du brevet :
**23.01.91 Bulletin 91/04**

(84) Etats contractants désignés :
**BE DE GB IT NL**

(56) Documents cités :
**EP-A- 0 128 799**
**WO-A-85/01390**
**CH-A- 446 463**
**FR-A- 2 507 409**

(73) Titulaire : **THOMSON-CSF**
**51, Esplanade du Général de Gaulle**
**F-92800 Puteaux (FR)**

(72) Inventeur : **Dubois, Michel**
**THOMSON-CSF SCPI 19, avenue de Messine**
**F-75008 Paris (FR)**

(74) Mandataire : **Benoit, Monique et al**
**THOMSON-CSF SCPI**
**F-92045 PARIS LA DEFENSE CEDEX 67 (FR)**

EP 0 221 809 B1

# Description

La présente invention concerne un circuit hybride et son procédé de fabrication.

Généralement un circuit hybride comporte des composants actifs et passifs, les composants actifs étant des chips (puces). Ces composants sont reliés les uns aux autres au moyen de pistes conductrices imprimées sur un substrat isolant. Ces pistes sont directement reliées aux pattes de connexions des entrées-sorties du circuit.

Or on est amené de plus en plus à intégrer des circuits sur un même substrat pour réaliser des fonctions plus complexes. Les liaisons électriques entre les différents composants sont par conséquent plus nombreuses. Pour éviter d'avoir une trop grande complexité dans les liaisons on effectue une étude d'implantation qui permet d'aboutir à la réalisation des connexions sur différents plans.

En effet, les pistes de connexion ne sont plus sur un même plan mais sur plusieurs plans isolés partiellement entre eux par des couches d'isolant. Le circuit se présente donc sous une forme multicouche les composants étant placés sur la dernière couche d'isolant et reliés aux pistes conductrices par les plots de connexion qui émergent à la surface. Un ensemble de liaisons électriques entre les différents composants sont enfermées entre les couches d'isolant et sont par conséquent inaccessibles.

Or, ces circuits étant complexes, il est nécessaire d'augmenter les tests sur les maquettes ou les prototypes sur tous les niveaux électriques, notamment aux entrées-sorties de chaque composant et sur chaque liaison électrique entre les différents composants. Par ailleurs, pour assurer une bonne maintenance après la fabrication série, il est également préférable d'accéder à tous ces niveaux.

Un autre inconvénient réside dans le fait que la période qui s'écoule entre l'étude topologique du circuit et le montage-câblage et qui comprend en particulier les phases d'implantation et de sérigraphie, est très longue.

La présente invention permet de remédier à ces inconvénients. Le circuit hybride selon l'invention est pour cela constitué de manière à ce qu'il permette une totale accessibilité à tous les niveaux de connexions électriques entre les différents composants, la durée de fabrication étant par ailleurs nettement raccourcie puisque les phases d'implantation des composants et de sérigraphie sont supprimées.

La présente invention a pour objet un circuit hybride comportant un substrat sur lequel sont fixés mécaniquement, des composants passifs et/ou actifs, et ayant les caractéristiques mentionnées dans la revendication 1.

La présente invention a également pour objet un procédé de fabrication d'un circuit hybride comportant les étapes mentionnées dans la revendication 4.

Un circuit hydride portant des composants connectés electriquement entre eux au moyen de fils conducteurs libres, isolés électriquement, disposés sur la face inférieure du substrat et reliés à des trous métallisés traversant ledit substrat est connu de EP-A-0128799.

Un circuit hydride dans lequel la liaison électrique entre les composants est effectuée par des tiges conductrices traversant le substrat et connectées au moyen d'un circuit imprimé disposé sur la face inférieure du substrat est connu de CH-A-446463.

D'autres particularités et avantages de l'invention apparaîtront clairement à la lecture de la description suivante présentée à titre d'exemple non limitatif et faite en regard des figures annexées qui représentent :

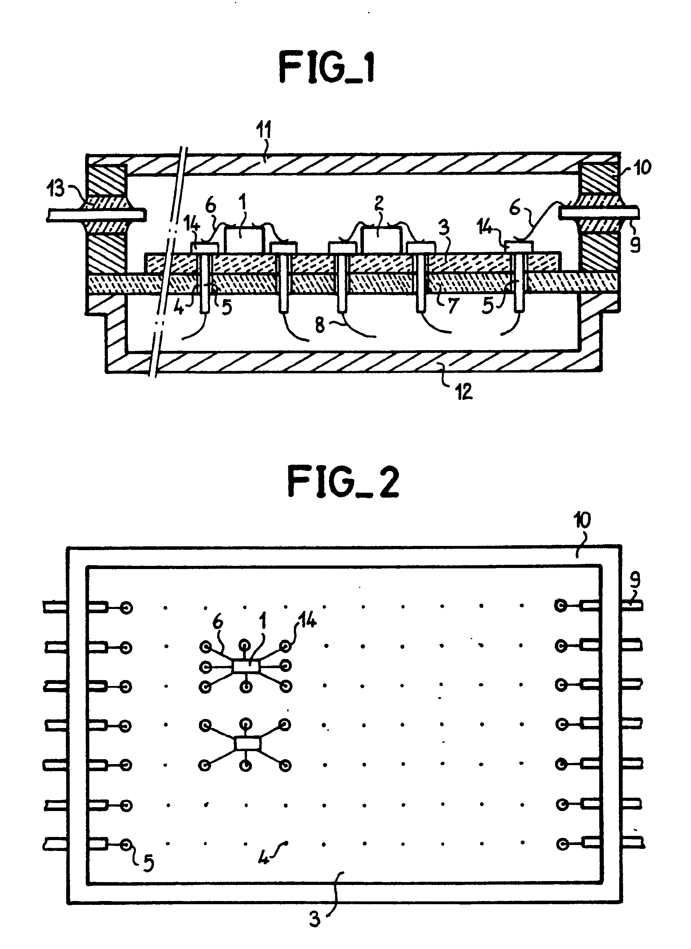

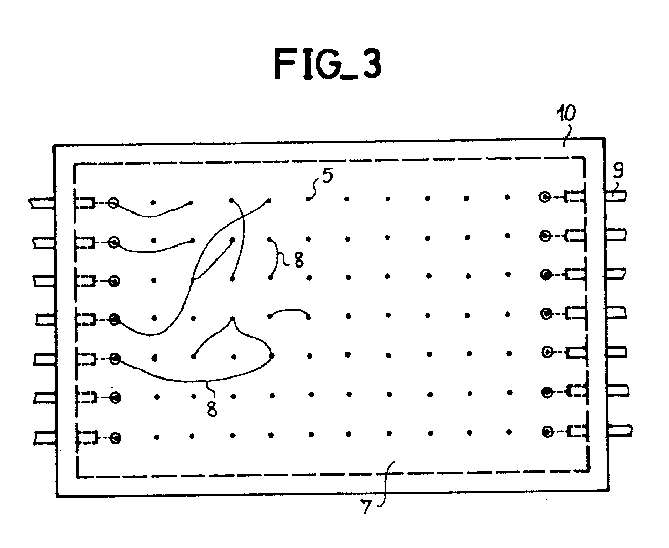

– figure 1, une coupe transversale du circuit selon l'invention ; – figures 2 et 3, une vue de dessus et de dessous du circuit selon l'invention.

Dans toute la description suivante, les mêmes références désignent les mêmes éléments.

On a représenté sur la figure 1 un circuit hybride selon l'invention, vu en coupe transversale.

Des composants 1, 2 (deux seulement sont représentés) actifs et/ou passifs sont fixés mécaniquement par exemple par collage sur un substrat 3. Ces composants sont généralement des chips (ou puces) et des éléments résistifs, capacitifs ou selfiques. Le substrat est constitué par exemple par une plaquette d'alumine. Le substrat 3 comporte des perforations c'est-à-dire des trous 4 qui traversent de part en part et dans lesquels, sont placées des tiges conductrices 5 qui émergent de part et d'autre de la plaquette constituant ce substrat. Les entrées-sorties des composants 1, 2, ces composants étant tous disposés sur une même face du substrat, sont reliées électriquement aux tiges 5 par des fils conducteurs 6. Sur l'autre face du substrat les tiges 5 émergent de manière à permettre le raccordement électrique entre les différents composants, ce raccordement est effectué par des fils conducteurs 8 isolés électriquement entre eux.

Dans cet exemple de réalisation particulière on a utilisé deux substrats superposés, ce qui facilite la fixation et le maintien des tiges 5 dans les trous 4. En effet, en collant les deux substrats 3 et 7 et en effectuant une pression sur ces deux substrats, la colle remonte dans l'espace situé entre le logement que constitue chaque trou et les tiges qui y sont placées.

Les tiges ont la forme d'un clou dont la tête repose sur une face du substrat 3 ce qui facilite également leur maintien. Le deuxième substrat 7 est également pourvu de trous dont l'emplacement coïncide avec l'emplacement des trous placés sur le substrat 3. Les tiges 5 émergent sous le substrat 7.

Les différentes entrées-sorties des composants sont reliées électriquement par les fils 6 aux tiges 5 sur une face du substrat 3. Les tiges 5 sont reliées entre elles sur l'autre face du deuxième substrat 7 par les fils 8, libres, isolés électriquement entre eux et placés au dessous du substrat 7.

On entend par fils libres, des liaisons électriques accessibles qui ne sont pas constituées de pistes imprimées sur un substrat et qui ne sont pas enfermées entre différentes couches d'isolant.

Les fils 8 relient les différentes tiges conformément au plan de conception du circuit pour que ce circuit puisse assurer sa fonction.

Les entrées et sorties du circuit sont reliées électriquement aux pattes de connexion externes 9. Cette liaison est réalisée par des fils libres 8 qui sont connectés sur la face de dessous du substrat 7 à des tiges 5 qui sont situées sur la périphérie du substrat, c'est-à-dire, proche des pattes de connexion 9. Chaque tige 5 étant connectée à une patte 9, sur la face du dessus du substrat 3 par un fil 6.

Un cadre métallique sert de support aux pattes 9. Les pattes sont disposées sur toute la périphérie du cadre, ou seulement sur deux côtés opposés (figure 2) conformément aux normes imposées pour les boîtiers. Le cadre est fermé au dessus par un couvercle 11 et au dessous par un capot 12, les termes de dessus et de dessous se réfèrent bien entendu à la représentation faite sur cette figure.

Les pattes de connexion 9 sont maintenues en place et isolées électriquement par un matériau constitué de perles de verre 13.

La figure 2 représente une vue de dessus du circuit, le couvercle 11 ayant été retiré. Le substrat 3 comporte un ensemble de trous disposés de manière matricielle pour faciliter la réalisation automatique par exemple. Les composants sont fixés sur le substrat et connectés aux têtes 14 des tiges 5. Des tiges 5 sont placées sur une rangée longeant chaque rangée de pattes de connexion 9.

La figure 3 représente la vue de dessous du circuit, le capot 12 ayant été retiré. Les fils 8 relient électriquement les différentes tiges 5.

Le procédé de réalisation du circuit hybride selon l'invention consiste dans le cas du premier mode de réalisation correspondant à la figure 1, à :
– percer les substrats 3 et 7 selon une configuration matricielle au moyen de dispositifs automatiques facilitant la fabrication série (par exemple un faisceau laser) ;
– assembler en une seule opération les deux substrats 3 et 7, ainsi que les tiges 5 et le cadre 10, cet assemblage est réalisé par une colle en préforme se présentant sous la forme d'une feuille disposée entre les deux substrats et qui après polymérisation en température et pression sur les substrats, assure le maintien mécanique de l'ensemble ;
– raccorder les tiges 5 entre elles, à l'aide de fils isolés 8 de faible diamètre soudés sur les extrémités de ces tiges 5 ;
– monter les composants sur le substrat 3 par collage à l'aide d'une résine du type époxyde ;
– raccorder les composants aux tiges 5 à l'aide des fils 6 selon les méthodes classiques ultrasoniques ou thermosoniques ;
– raccorder les tiges 5 aux pattes de connexions externes à l'aide des fils 6 selon les mêmes méthodes que précédemment ;
– souder le couvercle métallique 11 (par exemple en ferro-nickel) sur le cadre 10 par un procédé traditionnel de soudure électrique à la molette, sous atmosphère neutre, afin d'assurer l'herméticité de la cavité supérieure comportant les composants ;
– fixer le capot 12 par collage afin d'assurer l'étanchéité de la cavité inférieure.

La fermeture du circuit, c'est-à-dire la fixation du capot 12 et du couvercle 11 peut être réalisée par une soudure laser.

Les figures représentées concernent une configuration de boîtier du type Flat pack, bien entendu, l'invention s'applique à toute autre configuration notamment aux boîtiers du type dual-in-line.

Le circuit hybride dont deux exemples de réalisation ont été donnés permet de faciliter l'accès aux entrées-sorties de chaque composant et à toutes les liaisons électriques du circuit. Cette configuration permet de faciliter les tests pendant la phase de réalisation d'une maquette ou d'un prototype et de faciliter la maintenance après la fabrication série puisque toutes les connexions entre les divers composants sont accessibles.

Cette configuration permet en plus de raccourcir des délais de fabrication puisque les étapes traditionnelles d'implantation et de dépôt de couches conductrices et isolantes sont supprimées.

## Revendications

1. Circuit hybride comportant un premier substrat (3) percé de trous et sur lequel sont fixés mécaniquement des composants passifs et/ou actifs, les composants (1, 2) étant reliés entre eux au moyen de fils conducteurs (8) libres et isolés électriquement, caractérisé en ce que le circuit comporte un deuxième substrat (7) disposé sous le premier substrat et percé de trous en vis-à-vis des trous du premier substrat (3), des tiges conductrices (5) placées dans des trous des deux substrats assurant ainsi les liaisons électriques entre les entrées-sorties des composants et lesdits fils conducteurs (8) placés sous le deuxième substrat, et une feuille de collage disposée entre les deux substrats, cette dernière assurant l'assemblage et le maintien des deux substrats et des tiges conductrices (5).

2. Circuit selon la revendication 1, caractérisé en ce que les fils isolés (8) sont soudés par leurs extrémités aux extrémités des tiges qui émergent de la face opposée à la face du substrat qui est en contact avec les composants.

3. Circuit selon l'une des revendications précédentes, caractérisé en ce que le circuit comporte un cadre (10) porteur des pattes de connexion (9) externes disposé autour du substrat (7) et solidaire de celui-ci ; un couvercle (11) placé au-dessus du cadre et solidaire de celui ci, un capot (12) placé au-dessous du cadre et solidaire de celui-ci.

4. Procédé de fabrication d'un circuit hybride selon la revendication 1, caractérisé en ce qu'il consiste successivement :
– à perforer deux substrats ;
– à positionner une feuille de collage entre les deux substrats ;
– à passer des tiges conductrices dans les trous des substrats pour assurer des liaisons électriques d'une face à l'autre ;
– à assembler, par pression, en une seule opération les deux substrats ainsi que les tiges pour assurer le maintien mécanique de l'ensemble ;
– à monter les composants sur l'un des substrats ;
– à relier les entrées-sorties de chaque composant à une première extrémité de ces tiges par des fils conducteurs (6) et à relier électriquement les composants entre eux au moyen de fils conducteurs (8) libres, isolés électriquement entre eux et connectés à la deuxième extrémité de ces tiges.

5. Procédé de fabrication d'un circuit hybride selon la revendication 4, caractérisé en ce qu'il consiste à :
– percer les substrats (3 et 7) selon une configuration matricielle ;
– assembler en une seule opération les deux substrats (3 et 7), ainsi que les tiges (5) et un cadre (10) porteur des pattes de connexions externes (9), cet assemblage étant réalisé par une colle en préforme se présentant sous la forme d'une feuille disposée entre les deux substrats et qui après polymérisation en température et pression sur les substrats, assure le maintien mécanique de l'ensemble ;
– raccorder les tiges (5) entre elles, à l'aide de fils isolés (8) de faible diamètre soudés sur les extrémités de ces tiges 5 ;
– monter les composants sur le substrat (3) par collage à l'aide d'une résine du type époxyde ;
– raccorder les composants aux tiges (5) à l'aide des fils (6) selon les méthodes ultrasoniques ou thermosoniques ;
– raccorder les tiges (5) aux pattes de connexions externes à l'aide des fils (6) selon les mêmes méthodes que précédemment ;
– souder un couvercle métallique (11) sur le cadre (10) par un procédé de soudure électrique à la molette, sous atmosphère neutre, afin d'assurer l'herméticité de la cavité supérieure comportant les composants ;
– fixer le capot (12) par collage afin d'assurer l'étanchéité de la cavité inférieure.

## Ansprüche

1. Hybridschaltkreis mit einem ersten, von Löchern durchbohrten Substrat (3), auf welchem mechanisch passive und/oder aktive Bauelemente befestigt sind, wobei die Bauelemente (1, 2) miteinander über freie und elektrisch isolierte Leiterdrähte verbunden sind, dadurch gekennzeichnet, daß der Schaltkreis weiter ein zweites Substrat (7), das unter dem ersten Substrat angebracht ist und von Löchern, die den Löchern des ersten Substrats (3) gegenüberliegen, durchbohrt ist, Leiterstifte (5), die in Löcher der beiden Substrate eingesetzt sind und so die elektrische Verbindung zwischen den Ein/Ausgängen der Bauelemente und den unter dem zweiten Substrat angebrachten Leiterdrähten (8) herstellen, und eine Klebefolie aufweist, die zwischen den beiden Substraten angeordnet ist und den Zusammenbau und den Zusammenhalt der beiden Substrate und der Leiterstifte (5) sichert.

2. Schaltkreis nach Anspruch 1, dadurch gekennzeichnet, daß die isolierten Drähte (8) mit ihren Enden an die Enden der Stifte angelötet sind, welche aus derjenigen Substratfläche hervortreten, die der in Kontakt mit den Substraten stehenden Fläche gegenüberliegt.

3. Schaltkreis nach einem der vorhergehenden Ansprüche, dadurch gekennzeichnet, daß der Schaltkreis einen Rahmen (10) mit äußeren Anschlußfahnen (9), die um das Substrat (7) herum angeordnet sind und mit diesem fest verbunden sind, einen Deckel (11), der auf dem Rahmen angebracht und einen festen Bestandteil mit diesem bildet, und eine Haube (12) aufweist, die unter dem Rahmen angeordnet ist und einen festen Bestandteil mit diesem bildet.

4. Verfahren zur Herstellung eines hybriden Schaltkreises nach Anspruch 1, dadurch gekennzeichnet, daß das Verfahren die folgenden Schritte aufweist
– die beiden Substrate werden durchbohrt,
– ein Klebeblatt wird zwischen den beiden Substraten angebracht,
– die Leiterstifte werden in die Löcher des Substrats eingeführt, um die elektrischen Verbindungen von einer Seite zur anderen herzustellen,
– durch einmaliges gegenseitiges Andrücken werden die beiden Substrate sowie die Stifte zur Herbeiführung des mechanischen Zusammenhalts des Ganzen zusammengebaut,
– die Bauelemente werden auf einem der Substrate montiert,
– die Eingänge und Ausgänge jedes Bauelements werden durch Leiterdrähte (6) mit einem ersten Ende der Stifte verbunden, und die Bauelemente werden miteinander durch freie Leiterdrähte (8) elektrisch verbunden, die gegeneinander elektrisch isoliert und an das zweite Ende der Stifte angeschlossen sind.

5. Verfahren zur Herstellung eines hybriden Schaltkreises nach Anspruch 4, dadurch gekennzeichnet, daß es folgende Schritte aufweist

- die Substrate (3 und 7) werden entsprechend eine Matrix durchbohrt,

- in einem einzigen Arbeitsgang werden die beiden Substrate (3 und 7) sowie die Stifte (5) und einen Rahmen (10) mit äußeren Anschlußfahnen (9) zusammengebaut, wobei die Vereinigung mit Hilfe einer vorgeformten Leimschicht in Gestalt eines zwischen den beiden Substraten angebrachten Blatts herbeigeführt wird und der Leim nach dem Polymerisieren auf den Substraten unter Temperatur und Druck den mechanischen Zusammenhalt erwirkt,

- die Stifte (5) werden miteinander über isolierte Drähte (8) kleinen Durchmessers verbunden, die an den Enden der Stifte (5) angelötet sind,

- die Bauelemente werden auf dem Substrat (3) durch Leimen mit Hilfe eines Epoxyharzes montiert,

- die Bauelemente werden mit den Stiften (5) über Drähte (6) gemäß den Ultraschall- oder Wärmeschallmethoden verbunden,

- die Stifte (5) werden mit den äußeren Anschlußfahnen über Drähte (6) gemäß den gleichen Methoden wie den zuvor genannten verbunden,

- ein Metalldeckel (11) wird auf den Rahmen (10) durch ein elektrisches Rollnahtschweißverfahren unter neutraler Atmosphäre, zur Sicherung der Luftdichtigkeit des die Bauelemente enthaltenden oberen Hohlraums verlötet, und

- die Haube (12) wird durch Kleben zur Sicherung der Dichtheit des unteren Hohlraums befestigt.

## Claims

1. A hybrid circuit comprising a first substrate (3) which is pierced with holes and on which passive and/or active components (1, 2) are mechanically fixed, the components being interconnected by non-embedded and electrically insulated conductor wires (8), characterized in that the circuit comprises a second substrate (7) disposed beneath the first substrate and pierced with holes in alignment with the holes of the first substrate (3), conductor pins (5) placed in holes of the two substrates thereby ensuring the electric connections between the inputs-outputs of the components and said conductor wires (8) placed beneath the second substrate, and an adhesive foil disposed between the two substrates, said foil ensuring the assembling and the coherence of the two substrates and of the conductor pins (5).

2. A circuit according to claim 1, characterized in that the insulated wires (8) are soldered with their ends to the ends of the pins which emerge from the face opposite the face of the substrate which is in contact with the components.

3. A circuit according to any one of the preceding claims, characterized in that the circuit comprises a frame (10) provided with external connecting lugs (9) placed around the substrate (7) and integral therewith, a lid (11) placed on the upper side of the frame and integral with it, and a cap (12) placed on the lower side of the frame and integral with it.

4. A method for producing a hybrid circuit according to claim 1, characterized in that it consists successively in

- perforating the two substrates,

- positioning an adhesive foil between the two substrates,

- inserting conductor pins in the holes of the substrates in order to ensure the electrical links between one face and the other,

- assembling by pressing in a one stroke operation the two substrates as well as the pins in order to ensure the mechanical coherence of the assembly,

- mounting the components on one of the substrates,

- connecting the input-outputs of each component to a first end of said pins by means of conductor wires (6), and electrically interconnecting the components by means of non-embedded, electrically insulated conductor wires (8) which are in turn connected to the second end of said pins.

5. A method for producing a hybrid circuit according to claim 4, characterized in that it consists in

- piercing the substrates (3 and 7) according to a matrix pattern,

- assembling in a one-stroke operation the two substrates (3 and 7) as well as the pins (5) and a frame (10) provided with external connection lugs (9), said assembly being realized by using a preformed glue having the shape of a sheet disposed between the two substrates and ensuring the mechanical cohesion of the assembly after polymerisation by the application of temperature and pressure to the substrate,

- interconnecting the pins (5) by means of insulated wires (8) of small diameter soldered to the ends of said pins (5),

- glueing the components on the substrate (3) using an epoxy-type resin,

- connecting the components to the pins (5) by means of wires (6) according to the ultrasonic or thermosonic methods,

- connecting the pins (5) to the external connecting lugs by means of wires (6) according to the same methods as mentioned before,

- soldering a metal lid (11) onto the frame (10) by way of a roller seam welding method in a neutral atmosphere, in order to ensure tightness of the upper cavity including the components, and

- fixing the cap (12) by glueing in order to ensure the tightness of the lower cavity.

# FIG_1

# FIG_2

# FIG_3